# EUROPEAN PATENT APPLICATION

(11) **EP 1 701 218 A2**
(43) Date of publication of application: **13.09.2006**
(21) Application number: 06251063.1
(22) Date of filing: 01.03.2006
(51) Int. Cl.: G03F 7/42

(54) **Polymer remover**

(30) Priority: 11.03.2005 US 661249 P
(71) Applicant: Rohm and Haas Electronic Materials LLC, Marlborough, MA 01752 (US)
(72) Inventor: Auger, Robert L., Hopedale Massachusetts 01747 (US); Lachowski, Joseph F., Sutton Massachusetts 01590 (US)
(74) Representative: Kent, Venetia Katherine

(57) **Abstract**

Compositions useful for the removal of post-plasma processing polymeric residue from substrates, such as electronic devices, are provided. Also provided are methods of removing the post-plasma processing residues and methods of manufacturing integrated circuits using the compositions.

## Description

### Background of the Invention

The present invention relates generally to the field of removal of polymeric materials from a substrate. In particular, the present invention relates to compositions and methods for the removal of polymeric material following plasma processing in the manufacture of electronic devices.

Numerous materials containing polymers are used in the manufacture of electronic devices, such as integrated circuits, disk drives, storage media devices and the like. Such polymeric materials are found in photoresists, antireflective coatings, via filling layers, etch stop layers and the like. For example, modem technology utilizes positive-type resist materials for lithographically delineating patterns onto a substrate so that the patterns can be subsequently etched or otherwise defined into the substrate material. The resist material is deposited as a film and the desired pattern is defined by exposing the resist film to energetic radiation. Thereafter the exposed regions are subject to a dissolution by a suitable developer liquid. After the pattern has been thus defined in the substrate the resist material must be completely removed from the substrate to avoid adversely affecting or hindering subsequent operations or processing steps.

Pattern definition (or pattern transfer) techniques and polymeric removal techniques often involve one or more plasma processing steps, such as plasma etching, reactive ion etching, ion milling, plasma ashing and the like. Such plasma processing steps are conventionally used in the manufacture of integrated circuits and other electronic devices. During such plasma processing, polymeric material is generally removed however residue, including polymeric residue, remains on the substrate. Such "residue" includes photoresist (and other polymeric material) that was incompletely removed, sidewall polymer remaining on the sidewall of a wiring structure or in a recess such as a via, and an organometallic polymer and metal oxide that remains on the sidewall and/or in the base of the recess. This post plasma residue is not completely removed using conventional photoresist removers. For example, acetone or N-methylpyrrolidinone is currently used at extreme conditions, which include high temperature and extended cycle times. Such use conditions are often above the flashpoint of the solvent which raises certain environmental, health and safety issues regarding operator exposure. In addition, productivity and throughput are adversely affected by the extended process cycle times required. Even with such extreme stripping conditions, the devices may have to undergo wet strip followed by de-scum (O₂ plasma ash) and a subsequent wet clean for a wet-dry-wet strip process.

U.S. Patent No. 5,792,274 (Tanabe et al.) discloses a polymer removing composition containing a) a salt of hydrofluoric acid with a metal free base; b) water soluble organic solvent; c) water; and optionally d) an anticorrosive, the composition having a pH of 5-8. According to this patent, it is critical that the pH be kept within the range of 5-8. The compositions disclosed in this patent are not effective in removing post plasma processing residues under all conditions and suffer from one or more of short bath life, pH instability, and poor removal of post plasma processing residue.

In addition, other known stripping compositions for post-plasma processing residue removal applications have numerous drawbacks including, undesirable flammability, toxicity, volatility, odor, necessity for use at elevated temperatures such as up to 100° C, and high cost due to handling regulated materials. A particular problem with advanced next generation semiconductor devices is that known stripping compositions are incompatible with a variety of thin films in such devices, that is, such known stripping compositions cause corrosion of the thin films, specifically copper, and low-k dielectric material present in such advanced devices.

There is a continuing need for strippers and post plasma processing residue removers that effectively remove polymeric material, are more environmentally compatible, do not damage the features and geometries, do not cause corrosion of the substrate, particularly thin metal films, and do not etch dielectric layers in the substrate.

### Summary of the Invention

It has been surprisingly found that post plasma processing polymeric residue may be easily and cleanly removed from substrates, such as 100% copper substrates with dielectric materials. Such polymeric material may be removed according to the present invention without corrosion of underlying metal layers, specifically copper, and with reduced or eliminated etching of dielectric materials, such as silicon dioxide and low dielectric constant ("low k") materials such as hydrogen silsesquioxane, methyl silsesquioxane, polyarylene ethers, and the like. It has been further surprisingly found that compositions containing water are effective in removing polymeric material with reduced or eliminated etching of dielectric materials.

The present invention provides a composition including: a) a fluoride ion source; b) water; c) an organic acid compound chosen from trihaloacetic acid, organic polycarboxylic acid compounds, organic hydroxy-carboxylic acid compounds and amino acids; and optionally d) an organic solvent, the composition having a pH of ≤ 4.5.

Also provided by the present invention is a method of removing polymeric material, particularly post plasma processing residue, from a substrate including the step of contacting a substrate containing post plasma processing residue with the composition described above.

Further provided by the present invention is a method of manufacturing an integrated circuit including the steps of : a) depositing a layer of a polymeric material on a substrate used in the manufacture of an integrated circuit; b) subjecting the layer of polymeric material to a plasma process that provides a post plasma processing residue; and c) contacting the post plasma processing residue with the composition described above.

### Detailed Description of the Invention

As used throughout this specification, the following abbreviations shall have the following meanings unless the context clearly indicates otherwise: g = gram; ° C = degrees Centigrade; A = angstrom; %wt = percent by weight; nm = nanometer; mL = milliliter; UV = ultraviolet; min. = minute; PVD = physical vapor deposition; DI = deionized; AF = ammonium fluoride; ABF = ammonium bifluoride; TMAF = tetramethylammonium fluoride; EL = ethyl lactate; DPM = dipropylene glycol monomethyl ether; PGMEA = propylene glycol monomethyl ether acetate; PDO = 1,3-propanediol; and MP-diol = 2-methyl-1,3-propanediol.

The terms "stripping" and "removing" are used interchangeably throughout this specification. Likewise, the terms "stripper" and "remover" are used interchangeably. "Alkyl" refers to linear, branched and cyclic alkyl. The term "substituted alkyl" refers to an alkyl group having one or more of its hydrogens replaced with another substituent group, such as but not limited to halogen, cyano, nitro, (C₁-C₆)alkoxy, mercapto, and (C₁-C₆)alkylthio.

The terms "a" and "an" refer to the singular and the plural. All percentages are by weight. All numerical ranges are inclusive and combinable.

The compositions useful in the present invention include: a) a fluoride ion source; b) water; c) an organic acid compound chosen from trihaloacetic acid, organic polycarboxylic acid compounds, organic hydroxy-carboxylic acid compounds and amino acids; and optionally d) an organic solvent, the composition having a pH of ≤ 4.5. A wide variety of fluoride ion sources may be used. In one embodiment, the fluoride source is a salt of hydrofluoric acid with a metal-free base. Exemplary fluoride ion sources include, but are not limited to, ammonium fluoride, ammonium bifluoride, tetramethylammonium fluoride, trimethylammonium fluoride, ammonium-tetramethylammonium bifluoride, and monoethanolamine hydrofluoride. Mixtures of fluoride ion sources, such as a mixture of ammonium fluoride and ammonium bifluoride, may be used in the present invention. In general, the fluoride ion source is present in an amount of 0.01 to 8 %wt, based on the total weight of the composition. The fluoride ion source may be used in any suitable amount, such as up to the solubility limit of the fluoride ion source in the composition. In one embodiment, the fluoride ion source is present in an amount of >0.05 %wt, and more typically ≥ 0.1 %wt. In a further embodiment, the fluoride ion source is present in an amount of ≤ 5 %wt, such as from 0.05 to 5 %wt. The fluoride ion sources are generally commercially available, such as from Aldrich (Milwaukee, Wisconsin) and may be used as is without further purification.

Organic acids useful in the present invention are trihaloacetic acid, organic polycarboxylic acid compounds, organic hydroxy-carboxylic acid compounds and amino acids. Exemplary trihaloacetic acids include, but are not limited to, trifluoroacetic acid, trichloroacetic acid and tribromoacetic acid. The term "polycarboxylic acid compounds" refers to an organic compound containing two or more carboxylic acid groups. "Hydroxy-carboxylic acid compound" refers to an organic compound containing both at least one hydroxy group and at least one carboxylic acid group. Exemplary polycarboxylic acid compounds include, without limitation, oxalic acid, malonic acid, maleic acid, succinic acid, glutaric acid, adipic acid, and phthalic acid. Suitable hydroxy-carboxylic acid compounds include, but are not limited to, glycolic acid, lactic acid, citric acid, and tartaric acid. Exemplary amino acids include, but are not limited to, iminodiacetic acid, aspartic acid, aminoadipic acid, alanine, leucine, isoleucine, phenylalanine, glycine, cysteine, lysine, and valine. Mixtures of organic acid compounds may be used in the present compositions.

The organic acid compounds may be present in a wide range of amounts. In general, such compounds are present in an amount sufficient to improve the cleaning ability of the composition as compared to such compositions absent the organic acid compound. Typically, the organic acid compound is present in an amount of from 0.01 to 10 %wt, based on the total weight of the composition. More typically, the organic acid is present in an amount of 0.05 to 8 %wt, still more typically from 0.1 to 8 %wt and even more typically from 0.5 to 5 %wt. The organic acids are generally commercially available from a variety of sources, such as Aldrich and may be used as is without further purification.

While any suitable type of water may be used in the present invention, such as deionized, Milli-Q, distilled, and the like, deionized water is typically used. Any amount of water may suitably be used. The practical upper limit of water is about 99.5 %wt. Typically, water is present in an amount in the range of 5 to 95 %wt based on the total weight of the composition, more typically from 5 to 90 %wt, and still more typically from 10 to 85 %wt. Higher amounts of water in the present compositions are particularly useful in removing post plasma processing residues.

An organic solvent may optionally be used in the present compositions. Any solvent that is at least partially water-soluble may be used. In one embodiment, the organic solvent is water-miscible. Suitable organic solvents include, without limitation, alcohols, esters, ketones, ethers, and polar aprotic solvents. Mixtures of organic solvents may be used in the present invention. Organic solvents may be used in an amount of 0 to 90 %wt, based on the total weight of the composition. Typically, the organic solvent is present in an amount of 0 to 50 %wt, and more typically in an amount of 0 to 35 %wt. In one embodiment, the organic solvent is present in an amount of 10 to 35 %wt. In another embodiment, the organic solvent is ≤ 30 %wt.

Exemplary alcohols include methanol, ethanol, n-propanol, iso-propanol, n-butanol, isobutanol, sec-butanol, and non-cyclic polyol compounds. By the term "polyol compound" is meant a compound having two or more hydroxyl groups. Exemplary polyol compounds include without limitation aliphatic polyol compounds such as (C₂-C₂₀)alkanediols, substituted (C₂₋C₂₀)alkanediols, (C₂-C₂₀)alkanetriols, and substituted (C₂-C₂₀)alkanetriols. Suitable aliphatic polyol compounds include, but are not limited to, dihydroxypropanes such as 1,3-propanediol and propylene glycol, diethylene glycol, dipropylene glycol, triethylene glycol, tripropylene glycol, 2-methyl-1,3-propanediol, butanediol, pentanediol, hexanediol, and glycerol. Particularly useful aliphatic polyol compounds are 1,3-propanediol, propylene glycol, 2-methyl-propanediol, butanediol and pentanediol. Such polyol compounds are generally commercially available, such as from Aldrich and may be used without further purification. When a polyol compound is used in the present compositions, it is typically used in an amount of 5 to 85 %wt based on the total weight of the composition, and more typically from 10 to 70 %wt.

A wide variety of esters may be used as organic solvents in the present compositions. Exemplary esters include, without limitation, alkyl carboxylates such as ethyl acetate, butyl acetate, amyl acetate, ethyl lactate, ethyl adipate, and glycol esters such as propylene glycol methyl ether acetate.

Any suitable ketone may be used as the organic solvent in the present invention. Exemplary ketones include, but are not limited to, acetone, methyl ethyl ketone, and 2-heptanone.

A wide variety of ethers may be used as solvents in the present invention, including, but not limited to, cyclic ethers such as tetrahydrofuran and tetrahhydropyran, and glycol ethers. Exemplary glycol ethers include, without limitation, glycol mono(C₁-C₆)alkyl ethers and glycol di(C₁-C₆)alkyl ethers, such as but not limited to (C₁-C₂₀)alkanediol (C₁-C₆)alkyl ethers and (C₁₋C₂₀)alkanediol di(C₁-C₆)alkyl ethers. Suitable glycol ethers include, but are not limited to, ethylene glycol monomethyl ether, diethylene glycol monomethyl ether, propylene glycol monomethyl ether, propylene glycol dimethyl ether, propylene glycol mono-n-butyl ether, dipropylene glycol monomethyl ether, dipropylene glycol dimethyl ether, dipropylene glycol mono-n-butyl ether, and tripropylene glycol monomethyl ether. Such glycol ethers are generally commercially available and may be used without further purification. Typically, the glycol ethers are present in the compositions of the invention in an amount of 5 to 85 %wt based on the total weight of the composition, and more typically from 10 to 70 %wt.

Exemplary polar aprotic solvents include dimethylsulfoxide, sulfolane, dimethylformamide and dimethyl acetamide, although other polar aprotic solvents may be used. Still other suitable organic solvents useful in the present invention include, but are not limited to, aminoalcohols such as aminoethylaminoethanol, carbonates such as propylene carbonate, lactams such as N-methylpyrrolidone, and lactones.

In one embodiment, the present composition includes one or more polyol compounds and one or more glycol ethers. Typically, the one or more polyol compounds and the one or more glycol ethers are present in a ratio of 1:5 to 5:1. More typically, the ratio of the one or more polyol compounds to the one or more glycol ethers is 1:3 to 3:1 and still more typically 1:2 to 2:1.

The compositions of the present invention may optionally include one or more additives. Suitable additives include, but are not limited to, corrosion inhibitors and surfactants. Any corrosion inhibitor which reduces the corrosion of metal film layers is suitable for use in the present invention. Suitable corrosion inhibitors include, but are not limited to: catechol; (C₁₋C₆)alkylcatechol such as methylcatechol, ethylcatechol and tert-butylcatechol; benzotriazole; hydroxyanisole; (C₁-C₁₀)alkylbenzotriazoles; hydroxy(C₁-C₁₀)alkylbenzotriazoles; 2-mercaptobenimidazole; gallic acid; gallic acid esters such as methyl gallate and propyl gallate; and tetra(C₁-C₄)alkylammonium silicates such as tetramethylammonium silicate. Such corrosion inhibitors are generally commercially available from a variety of sources, such as Aldrich, and may be used without further purification.

When such corrosion inhibitors are used in the compositions of the present invention, they are typically present in an amount of 0.01 to 10 %wt, based on the total weight of the composition. More typically, the corrosion inhibitor is from 0.2 to 5 %wt, even more typically 0.5 to 3 %wt, and still more typically from 1.5 to 2.5 %wt.

Nonionic, anionic and cationic surfactants may be used in the compositions of the present invention. Nonionic surfactants are typically employed. Such surfactants are generally commercially available. The surfactants are typically present in an amount of 0.2 to 5 %wt, more typically from 0.5 to 3 %wt, and still more typically from 1 to 2.5 %wt, based on the total weight of the composition.

Particularly useful compositions of the present invention are those including from 0.05 to 5 %wt of a fluoride ion source, from 0.1 to 8 %wt of an organic acid compound, from 0 to 50 %wt of an organic solvent and the balance being water.

The present compositions have a pH of ≤ 4.5. More typically, the pH of the compositions is ≤ 4, still more typically ≤ 3.5 and yet more typically ≤ 3. In one embodiment the pH of the present compositions is from 0 to 4.5. In another embodiment, the pH of the compositions is from 1 to 3.5. Compositions of the present invention having lower pH values, i.e. a higher acid content, provide better cleaning that similar compositions having a higher pH value, i.e. a lower acid content.

The compositions of the present invention may be prepared by combining fluoride ion source, organic acid compound, water, optional organic solvent and optional additives in any order. In one embodiment, water is first added to a vessel and then the remaining components are added in any order.

The compositions of the present invention are suitable for removing post-plasma etch polymeric material from a substrate. Any polymeric material, such as, but not limited to, photoresists, soldermasks, antireflective coatings, and the like, that have been subjected to plasma process conditions such as bur not limited to plasma etching, plasma ashing, ion implantation and ion milling processes, can be effectively removed from a substrate according to the present invention. It will be appreciated by those skilled in the art that the present invention is equally suited for the removal of polymeric material that has not been subjected to plasma processing.

Polymeric residue, particularly post plasma processing polymeric residue, on a substrate may be removed by contacting the residue with a composition of the present invention. The substrate containing the residue is contacted with the present compositions for a time sufficient to remove the residue from the substrate. The residue may be contacted with the compositions of the present invention by any suitable means, such as immersion of the substrate in a bath, such as a wet chemical bench, containing a composition of the present invention, or by spraying a composition of the present invention on the surface of the substrate. Following contact with the remover compositions of the present invention, the substrate is typically rinsed such as with deionized water, and then dried such as by spin drying. When the compositions of the present invention are sprayed on a substrate, such spraying operation is typically performed in a spray chamber such as a solvent cleaning spray apparatus available from Semitool, Inc. (Kalispell, Montana).

The present remover compositions may be used at room temperature or heated. Typically, the polymeric residue removal process of the present invention may be carried out at ambient temperature, or at any temperature such as from room temperature to 80° C, preferably from 20° C to 65° C, and more preferably from 20° C to 50° C.

A further advantage of the compositions of the present invention is that they may be effectively used to remove polymeric material from substrates including one or more dielectric layers without substantially etching the dielectric material. Typically, the compositions of the present invention remove unwanted post plasma processing residue while showing reduced or eliminated etching of other materials on the substrate such as dielectric materials, metal lines, and barrier layers. Thus, the present compositions are compatible with a wide variety of materials used in the manufacture of electronic devices such as dielectric materials, particularly low dielectric constant ("low-k") materials, such as, but not limited to, siloxanes, silicon dioxides, silsesquioxanes such as hydrogen silsesquioxane, methyl silsesquioxane, phenyl silsesquioxane and mixtures thereof, benzocyclobutenes, polyarylene ethers, polyaromatic hydrocarbons, and fluorinated silicon glasses. A still further advantage of the compositions of the present invention is that post-plasma processing polymeric residue may be removed from a substrate without etching of thermal oxide layers underneath metal lines.

The compositions of the present invention are particularly useful in removing post plasma processing residues, particularly polymeric residues, when other conventional strippers are not capable of removing such residues. Furthermore the present compositions are substantially noncorrosive to substrates containing metals, particularly copper and aluminum.

In another embodiment, the present compositions are highly effective in the removal of photoresist coated on a layer of hard to remove organic, cross-linked polymeric anti-reflective coating ("ARC") polymer. It is very well known that such ARCs are cross-linked polymeric material that are very difficult to remove by conventional photoresist strippers.

In order to achieve sub-half micron geometry metal lines and high aspect ratio via openings, deep-UV photoresist and the corresponding ARC layer are treated with fluorinated plasma gas, such as that used with high density plasma etchers. The deep-UV positive acting photoresist and the ARC polymer become highly cross-linked under such conditions, leaving behind fluoro-organometallic polymer residues that are very difficult to remove by conventional stripping methods. It has been surprisingly found that the compositions of present invention effectively remove such polymeric residues at ambient temperature and at relatively short processing times.

In one embodiment, the present invention provides a method of manufacturing an integrated circuit including the steps of : a) depositing a layer of a polymeric material on a substrate used in the manufacture of an integrated circuit; b) subjecting the layer of polymeric material to a plasma process that provides a post plasma processing residue; and c) contacting the post plasma processing residue with the composition described above.

Thus, the compositions of the present invention are useful in other applications where harsh or extreme processing conditions occur, such as, but not limited to, flat panel display TFT/LCD manufacture, magneto-resistive and giant magneto-resistive thin film head manufacture, and read-write device manufacture. The compositions of the present invention are substantially inert to the metal films used in magneto-resistive and giant magneto-resistive thin film head manufacture such as, but not limited to, aluminum oxide ("Al₂O₃"), gold ("Au"), cobalt ("Co"), copper ("Cu"), iron ("Fe"), iridium ("Ir"), manganese ("Mn"), molybdenum ("Mo"), nickel ("Ni"), platinum ("Pt"), ruthenium ("Ru"), and zirconium ("Zr"), as well as other metals used in the manufacture of semiconductors and electronic materials, such as, but not limited to, copper, aluminum, nickel-iron, tungsten, titanium, titanium-nitride, tantalum, tantalum nitride.

The following examples are expected to illustrate further various aspects of the present invention, but are not intended to limit the scope of the invention in any aspect.

### Example 1

Compositions were prepared by combining the components in the following table in the amounts indicated. The abbreviation "BTA" refers to benzotriazole and the abbreviation "TBC" refers to tert-butyl catechol. The pH of each of the samples was measured as a 5% solution in DI water (i.e. a solution of D! water containing 5 %wt of the respective sample composition).

| **Sample** | **Fluoride ion source (%wt)** | **DI Water (%Wt)** | **1,3-Propane diol (%wt)** | **DPM (%wt)** | **Organic acid (%Wt)** | **Other components (%wt)** | **pH** |
|---|---|---|---|---|---|---|---|
| 1 | ABF (0.13) | 72.87 | 12.5 | 12.5 | Citric acid (2) | - | 3.6 |
| 2 | ABF (0.13) | 73.5 | 12.5 | 12.5 | Oxalic Acid (1.3) | - | 2.5 |
| 3 | ABF (0.18) | 55.12 | 22 | 22 | Oxalic Acid (0.7) | - | 2.6 |
| | | | | | | | |
| Comparative 1 | ABF (0.65) AF (1.15) | 32.1 | 32.1 | 32.1 | - | BTA (1) TBC (1) | 3.8 |
| Comparative 2 | ABF (0.13) | 70.87 | 12.5 | 12.5 | Acetic acid (4) | - | 4.9 |
| Comparative 3 | - | 96.9 | 0 | 0 | Oxalic acid (3.4) | - | 1.2 |

### Example 2

Silicon wafer pieces (approximately 2.5 x 2.5 cm) containing a dual damascene structure having a carbon-doped oxide dielectric material and copper, with a tetraethylorthosilicate ("TEOS") layer on the dielectric material and a TiN layer on the TEOS layer and containing a post-plasma ash residue were cleaned using the Samples of Example 1. A wafer piece was immersed in a beaker containing one of the Samples of Example 1 at room temperature (approx. 20° C). After 3 minutes of immersion, the wafer piece was removed from the beaker, washed with DI water and dried. Scanning electron micrographs ("SEMs") of the cleaned wafer pieces were examined and the results are reported in the following table. The percentage of residue removed was based on visual examination of the SEMs as compared to SEMs of the wafer pieces before cleaning. The cap layer etch was visually determined from the SEM images.

| **Sample** | **Residue removed (%)** | **Cap layer etch (nm)** |
|---|---|---|
| 1 | 80 | 5 |
| 2 | 90 | 0 |
| 3 | 100 | 2 |
| Comparative 1 | 10 | 60 |
| Comparative 2 | 40 | 5 |
| Comparative 3 | 0 | 0 |

It is clear from these results that the present compositions are effective in removing post plasma processing residue. The lower cap layer etch rates are indicative of less undercutting.

### Example 3

Silicon wafer pieces (approximately 2.5 x 2.5 cm) containing a thermally grown copper oxide film (approximately 380 Å) were cleaned using the Samples reported in the following table. The wafer pieces were immersed in each Sample in a beaker at room temperature for the times reported in the table. After the appropriate times, each sample was removed from the beaker, rinsed with DI water and dried. The organic solvent used in the comparative samples was a 1:1 (by weight) mixture of PDO and DPM.

The reflectivity of each wafer piece was determined using a conventional reflectometer at 408 nm. The reflectomoeter was calibrated such that pure, clean, acid-washed copper (no oxide) has a reflectivity of 100%. Using the calibrated reflectometer, untreated copper oxide has a reflectivity of 2%.

| **Sample** | **Formulation** | **1 Min.** | **2 Min.** | **3 Min.** | **4 Min.** |
|---|---|---|---|---|---|
| 3 | See Example 1 | 100% | 100% | 100% | 100% |
| Comparative 4 | ABF (0.178); water (62.3); organic solvent (37.5) | 93% | 100% | 100% | 100% |
| Comparative 5 | ABF (0.178); water (55.8); organic solvent (44) | 70% | 90% | 93% | 100% |
| Comparative 6 | ABF (0.18); water (49.8); organic solvent (50) | 45% | 80% | 85% | 93% |
| Comparative 7 | AF (3.25); water (25); organic solvent (67.8); BTA (4) | 7% | 10% | 18% | 22% |

From the above data, it is clear that the compositions of the present invention are effective in removing metal oxides.

### Example 4

Silicon wafer pieces (approximately 2.5 x 2.5 cm) were immersed in a beaker containing Sample 3 from Example 1 at room temperature. The wafer pieces contained different top layers of material as reported in the following table. The wafer pieces were removed from the beaker after 3 minutes of immersion time, rinsed with DI water and dried. The cleaned wafer pieces were evaluated by scanning electron microscopy to determine the amount of the top layer that had been etched by the remover formulation. The results are reported in the following table.

| **Top Layer on Wafer** | **Etch Rate (Å/min.)** |
|---|---|
| Electroplated copper | 3.0 |
| PVD copper | 4.0 |
| TEOS | 4.4 |
| Fluorinated silicon glass | 7.3 |
| carbon-doped oxide dielectric material | 0 |
| Titanium nitride ("TiN") | 0 |

The above data clearly show that the present compositions have very low etch rates.

### Example 5

The compositions in the following table are expected to perform similarly to those of Example 1.

| Sample | Fluoride ion source (%wt) | DI Water (%wt) | Organic Solvent (%wt) | Organic acid (%wt) | Other components (%wt) |
|---|---|---|---|---|---|
| 4 | ABF (0.5) | 62 | DPM (15) MP-diol (20) | Citric acid (2.5) | - |
| 5 | ABF (0.1) AF (1.5) | 70.9 | PDO (25) | Aspartic acid (2.5) | - |
| 6 | AF (2) | 55 | PGMEA (12) EL (29) | Malonic Acid (1.3) | Nonionic surfactant (0.7) |
| 7 | AF (2.1) | 69.8 | MP-diol (23) | Tartaric acid (5) | Gallic acid (0.1) |
| 8 | ABF (0.75) | 79.25 | PDO (16.5) | Oxalic acid (1.5) Glycine (2) | - |
| 9 | TMAF (0.7) AF (2.2) | 94.6 | 0 | Oxalic acid (0.5) Citric acid (2) | - |
| 10 | AF (3.5) | 93 | 0 | Aspartic acid (3.5) | - |
| 11 | AF (3.7) | 92 | 0 | Trifluoroacetic acid (4.3) | - |

## Claims

1. A composition comprising: a) a fluoride ion source; b) water; c) an organic acid compound chosen from trihaloacetic acid, organic polycarboxylic acid compounds, organic hydroxy-carboxylic acid compounds and amino acids; and optionally d) an organic solvent, the composition having a pH of ≤ 4.5.

2. The composition of claim 1 wherein the fluoride ion source is chosen from ammonium fluoride, ammonium bifluoride, tetramethylammonium fluoride, trimethylammonium fluoride, ammonium-tetramethylammonium bifluoride, monoethanolamine hydrofluoride and mixtures thereof.

3. The composition of claim 1 wherein the organic acid compound is chosen from oxalic acid, malonic acid, maleic acid, succinic acid, glutaric acid, adipic acid, phthalic acid, glycolic acid, lactic acid, citric acid, tartaric acid, iminodiacetic acid, aspartic acid, aminoadipic acid, alanine, leucine, isoleucine, phenylalanine, glycine, cysteine, lysine, valine, and mixtures thereof.

4. The composition of claim 1 wherein the pH is ≤ 4.

5. The composition of claim 1 further comprising one or more of a corrosion inhibitor and a surfactant.

6. The composition of claim 1 wherein the water the organic solvent is chosen from alcohols, esters, ketones, ethers, polar aprotic solvents, aminoalcohols, carbonates, lactams, and lactones.

7. The composition of claim 1 further comprising a polyol compound and a glycol ether.

8. The composition of claim 1

9. A method of removing residue from a substrate comprising the step of contacting a substrate containing post plasma processing residue with the composition of claim 1.

10. A method of manufacturing an integrated circuit comprising the steps of : a) depositing a layer of a polymeric material on a substrate used in the manufacture of an integrated circuit; b) subjecting the layer of polymeric material to a plasma process that provides a post plasma processing residue; and c) contacting the post plasma processing residue with the composition of claim 1.
